(19) Europäisches Patentamt / European Patent Office / Office européen des brevets

(11) **EP 2 144 179 A1**

(12) **DEMANDE DE BREVET EUROPEEN**

(43) Date de publication:
**13.01.2010 Bulletin 2010/02**

(51) Int Cl.:
***G06F 17/50*** *(2006.01)*

(21) Numéro de dépôt: **09290527.2**

(22) Date de dépôt: **01.07.2009**

| | |
|---|---|
| (84) Etats contractants désignés:<br>**AT BE BG CH CY CZ DE DK EE ES FI FR GB GR HR HU IE IS IT LI LT LU LV MC MK MT NL NO PL PT RO SE SI SK SM TR** | (72) Inventeur: **de Crecy, François**<br>**38180 Seyssins (FR)** |
| (30) Priorité: **08.07.2008 FR 0803874** | (74) Mandataire: **Priori, Enrico et al**<br>**Cabinet Orès**<br>**36, rue de St. Pétersbourg**<br>**75008 Paris (FR)** |
| (71) Demandeur: **Commissariat à l'Energie Atomique**<br>**Bâtiment D "Le Ponant"**<br>**25 rue Leblanc**<br>**75015 Paris (FR)** | |

(54) **Procédé de construction d'un métamodèle de simulation de données techniques**

(57) L'invention est relative à un procédé pour interpoler des données techniques à partir de simulations constituant une base d'apprentissage comportant des vecteurs de données techniques $X_i$, i variant de 1 à n, présentant chacun des composantes $x_i^{(k)}$, k variant de 1 à d, caractérisé en ce que le métamodèle est une spline d'interpolation ou de quasi interpolation multidimensionnelle pseudo-cubique de type plaque mince ayant une fonction analytique f(X)

$$f(X) = \sum_{i=1}^{n} \lambda_i \|X - X_i\|^3 + \sum_{k=1}^{d} \alpha_k x^{(k)} + \alpha_o$$

$$\|X - X_i\|^2 = \sum_{k=1}^{d} dil_k^2 \left( \frac{x^{(k)} - x_i^{(k)}}{\sigma_k} \right)^2$$

$\sigma_k$ désignant l'écart type des $k^{eme}$ composantes $X_i^{(k)}$ des vecteurs $X_i$
et $dil_k$ la dilatation d'échelle associée à ladite $k^{eme}$ composante
$\lambda_i$ et $\alpha_k$ étant les solutions d'un système linéaire symétrique de dimension $(n + d + 1)^2$ :

$$\sum_{j=1}^{n} \lambda_j \cdot \|X_j - X_i\|^3 + \frac{\lambda_i}{\rho \omega_i} + \sum_{k=1}^{d} \alpha_k \cdot x_i^{(k)} + \alpha_O = y_i$$

pour i ∈ {1, 2, 3, ... , n}

**(Cont. page suivante)**

$$\sum_{j=1}^{n} \lambda_j \cdot x_j^{(k)} = 0$$

pour $k \in \{1,2,3,...,d\}$

$$\sum_{j=1}^{n} \lambda_j = 0$$

$Y_i$ désignant la valeur de la réponse pour la $i^{eme}$ simulation pour la valeur $X_i$ des paramètres.

FIG.1

**EP 2 144 179 A1**

**Description**

L'invention proposée concerne l'aide à l'analyse de données techniques obtenues par un procédé de simulation technique ou scientifique ou d'ingénierie. Elle peut donc concerner une très large gamme d'applications dans de nombreux secteurs techniques et scientifiques, parmi lesquels on peut citer à titre d'exemple la microélectronique et les micro- et nano-technologies (avec par exemple les logiciels de "TCAD" (Technology Computer Aided Design), les logiciels de "SPICE" (Simulation Program with Integrated Circuit Emphasis)), la construction automobile, aéronautique ou spatiale, le bâtiment et les travaux publics, la chimie, l'extraction minière, pétrolière et gazière, l'énergie, l'agro-alimentaire, le transport, la finance, le traitement numérique de données audio et/ou vidéo.

Dans tous ces domaines, l'homme de l'art désire souvent comprendre ou visualiser un phénomène, ou optimiser une pièce, un dispositif ou procédé, ou faire des études de sensibilité, de variabilité ou de la modélisation inverse, ou faire des études statistiques ou de rendement, ou créer des programmes qui simulent certains résultats dans une gamme fixée de paramètres.

Pour parvenir à son but, l'homme de l'art a souvent à sa disposition des logiciels techniques ou scientifiques ou d'ingénierie qui permettent de simuler le dispositif, phénomène ou concept étudié, et plus particulièrement des procédés qui se caractérisent par les faits suivants :

- l'homme de l'art décrit le dispositif ou phénomène ou concept étudié dans un langage ou avec des jeux de données et avec une méthodologie propre. Pour cela, il fait intervenir un certain nombre de "paramètres", c'est-à-dire de grandeurs numériques lui permettant de décrire son dispositif (par exemple la géométrie du dispositif, les propriétés physiques des matériaux ou des caractéristiques des parties ou des sous-ensembles du dispositif) ou phénomène ou concept étudié, ou encore qui conditionnent la mise en oeuvre du procédé (par exemple le maillage, des paramètres ou choix algorithmiques ou numériques). Ces "paramètres" sont choisis par l'homme de l'art dans une certaine gamme possible.

- les résultats sont caractérisés par une ou (plus généralement) plusieurs "réponses" numériques qui renseignent l'homme de l'art sur le dispositif ou pièce ou procédé ou phénomène ou concept étudié.

- le procédé est déterministe, c'est-à-dire que si l'homme de l'art utilise plusieurs fois le même procédé avec les mêmes paramètres sur le même ordinateur, il aura à chaque fois les mêmes "réponses" numériques.

Les procédés connus de simulation technique ou scientifique ou d'ingénierie sont souvent assez lourds, c'est-à-dire qu'ils demandent beaucoup de temps de processus (CPU) et/ou de ressources mémoire et/ou de place d'archivage. Ceci implique qu'il est souvent difficile ou impossible de le mettre en oeuvre sur un grand nombre de cas, par exemple quelques milliers, ou dizaines de milliers, ou centaines de milliers, ou millions de cas, chaque cas étant défini par la valeur des différents paramètres. Or il est souvent nécessaire à l'homme de l'art de pouvoir estimer ce que seraient les réponses pour un nombre élevé de cas. Il lui faut donc un moyen d'avoir ces estimations.

Pour arriver à son objectif (qui est souvent de comprendre ou visualiser un phénomène, ou d'optimiser un dispositif ou procédé, ou de faire des études de sensibilité, de variabilité ou de la modélisation inverse, ou de faire des études statistiques ou de rendement, ou de créer des programmes qui simulent certains résultats dans une gamme fixée de paramètres), il est connu de construire des "métamodèles".

Un "métamodèle" est ici défini comme une fonction analytique, que l'on souhaite rapide à calculer par ordinateur, qui représente une réponse et qui dépend de plusieurs paramètres numériques. Ce "métamodèle", parce qu'il est très rapide à calculer, remplace le logiciel complet pour de nombreuses applications, par exemple la visualisation des phénomènes, l'optimisation, les études de sensibilité, de variabilité ou de modélisation inverse, les études statistiques ou de rendement, etc ...

Un tel métamodèle est construit à partir d'un certain nombre de simulations et pour lesquelles les paramètres varient dans un certain domaine. Il est conseillé de choisir ces simulations suivant des techniques de plans de simulations numériques, par exemple décrites par Thomas J. Santner, Brian J. Williams, William I. Notz, "Design and Analysis of Computer Experiments", Springer Series in Statistics, 2003

On appelle "base d'apprentissage" un tel ensemble de simulations faites avec le procédé et qui servent à bâtir le métamodèle. Typiquement, cette base d'apprentissage contient de quelques dizaines à plusieurs centaines ou plusieurs milliers de simulations représentés par des vecteurs d'apprentissage, mais il n'y a aucun inconvénient à ce qu'elle en comporte moins ou plus.

Vu que le procédé que nous considérons est déterministe, il y a une parfaite reproductibilité des réponses, et il est très fortement préférable que le métamodèle, appliqué à l'un des points de la base d'apprentissage, redonne soit exactement la valeur de réponse obtenue par le logiciel en ce point, soit une valeur très proche, c'est-à-dire que le métamodèle soit un "interpolateur" ou un "quasi-interpolateur". Un interpolateur est un métamodèle qui passe exactement par tous les points d'apprentissage, alors qu'un quasi-interpolateur est un métamodèle qui passe très près de tous les points d'apprentissage.

3

Par "très près de tous les points de la base d'apprentissage", il faut comprendre que la variance résiduelle doit être petite par rapport à la variance totale, par exemple inférieure à 0,01 fois la variance totale ou, mieux, par exemple inférieure à 0,001 fois la variance totale ou, encore mieux, par exemple inférieure à 0,0001 fois la variance totale.

La variance résiduelle est ici définie (très classiquement) par :

$$Var\_résid = \sum_{j=1}^{n} \omega_j \cdot (R_{simulation,j} - R_{méta\,mod\,èle}(X_j))^2$$

et la variance totale est ici définie (classiquement) par :

$$Var\_totale = \sum_{j=1}^{n} \omega_j \cdot (R_{simulation,j} - <R_{simulation}>)^2$$

Les $\omega_j$ sont des poids tous positifs ou nuls (par défaut et si il n'y a pas de poids prédéfinis, tous les poids $\omega_j$ sont pris égaux à 1). n est le nombre de simulations dans la base d'apprentissage. $X_j$ est le vecteur représentant l'ensemble des paramètres pour la $j^{ème}$ simulation $R_{simulation,j}$ est la valeur de la réponse pour la $j^{ème}$ simulation, $R_{métamodéle}(X_j)$ est le métamodèle associé à cette réponse. $<R_{simulation}>$ est la moyenne pondérée par les poids $\omega_j$ de toutes les simulations de la base d'apprentissage.

Une première manière connue de construire ce métamodèle est de le chercher sous forme d'un polynôme dépendant des divers paramètres. Dans ce cas, le métamodèle est souvent nommé "surface de réponse", quoique cette appellation regroupe parfois, chez certains auteurs, un ensemble plus vaste de métamodèles. Par exemple, la réponse R représentée par un polynôme de degré total q dépendant de d variables $x_1$ , $x_2$, ... , $x_k$, ... ,$x_d$ s'écrit:

$$R = \sum \alpha_{i_1\, i_2\, ...\, i_k\, ...\, i_d} \cdot x_1^{i_i} \cdot x_2^{i_2} \cdot ... \cdot x_k^{i_k} \cdot ... \cdot x_d^{i_d}$$

avec, pour tous les $i_k$, $0 \leq i_k \leq q$ et le degré total est q , c'est-à-dire que les coefficients

$$\alpha_{i_1\, i_2\, ...\, i_k\, ...\, i_d}$$

sont nuls si la somme $i_1 + i_2 + ... + i_k + ... + i_d$ est supérieure à q.

Les coefficients

$$\alpha_{i_1\, i_2\, ...\, i_k\, ...\, i_d}$$

définissent le polynôme. Pour les déterminer, la méthode la plus classique est de faire une régression aux moindres carrés. Cela revient à minimiser la somme S des carrés (éventuellement pondérés) des écarts entre réponse réellement simulée (issue du logiciel scientifique ou technique), c'est-à-dire la variance résiduelle :

$$S = \sum_{j=1}^{n} \omega_j \cdot \left( R_{simulation,\,j} - R_{méta\,mod\grave{e}le}(X_j) \right)^2$$

Les poids $\omega_j$ sont tous positifs ou nuls. $X_j$ est le vecteur représentant l'ensemble des paramètres pour la j$^{ème}$ simulation, $R_{simulation,\,j}$ est la valeur de la réponse pour la j$^{ème}$ simulation, $R_{métamodèle}$ est le métamodèle associé à cette réponse.

Les détails sur les régressions aux moindres carrés et sur les méthodes utilisées pour déterminer les valeurs numériques des coefficients $\alpha_{i_1\,i_2...\,i_k\,...id}$ sont connus de l'homme de l'art et sont par exemple décrits dans G.E.P. Box & N.R. Draper, "Empirical Model-Building and Response Surfaces", Wiley series in Probability and Mathematical Statistics, 1987 ou bien encore W.H. Press; S.A. Teukolsky, W.T. Vetterling, B.P. Flannery, "Numerical Recipes, The Art of Scientific Computing, third edition", Cambridge University Press, 2007.

Le principal inconvénient de la construction d'un métamodèle par des polynômes est le dilemme suivant :

- soit on impose que le métamodèle soit un interpolateur et alors on est obligé d'avoir un polynôme de degré total relativement élevé avec souvent un nombre total de coefficients $\alpha_{i_1\,i_2...\,i_k\,...id}$ non nuls égal (ou à peine inférieur) au nombre de simulations dans la base d'apprentissage. Dans ce cas il est connu de l'homme de l'art que le comportement du polynôme est extrêmement chaotique en interpolation et encore plus en extrapolation, rendant ces interpolations et extrapolations peu fiables.
- soit on impose un nombre plus limité de coefficients non nuls dans le polynôme pour s'assurer d'un comportement peu chaotique en interpolation et extrapolation. L'homme de l'art connaît plusieurs manière de choisir ces coefficients et de déterminer leurs valeurs: ces manières sont souvent basées sur l'analyse de la variance et sont décrites par exemple dans l'ouvrage précité de G.E.P BOX et N. DRAPER. Mais cette manière de faire présente plusieurs gros inconvénients : les fondements théoriques statistiques sont basés sur un modèle où la réponse obtenue peut être considérée comme le résultat d'un tirage d'une fonction aléatoire, ce qui n'est pas du tout le cas ici. De plus le métamodèle ainsi obtenu n'est pas un interpolateur ni un quasi-interpolateur, alors que nous avons vu qu'il était nettement préférable qu'il le soit.

Pour pallier ces inconvénients, l'homme de l'art utilise de plus en plus fréquemment les méthodes diverses de krigeage ("kriging" en anglais) pour construire son métamodèle. Une bonne introduction à ces méthodes de krigeage (issues de la géostatistique) peut être trouvée par exemple dans l'ouvrage précité de Thomas J. SANTNER et collaborateurs. Le krigeage est une méthode d'interpolation spatiale, parfois considérée comme la plus juste d'un point de vue statistique, qui permet une estimation linéaire basée sur l'espérance mathématique et aussi sur la variance de la donnée spatialisée. Il fait intervenir la fonction de corrélation entre la valeur de la fonction aux points $X_i$ et $X_j$, $X_i$ et $X_j$ représentant chacun un jeu de valeurs numériques des d paramètres, donc par exemple chacun une simulation par le logiciel. Mathématiquement, ce sont des éléments de $\Re^d$, c'est-à-dire des vecteurs constitués de d termes réels ($\Re$ étant l'ensemble des nombres réels), et l'hypothèse de base est que cette fonction de corrélation ne dépend que d'une "distance" au sens mathématique du terme entre les points $X_i$ et $X_j$, notée $\lVert X_i - X_j \rVert$ et qui peut être définie par exemple par :

$$\lVert X_i - X_j \rVert = \sqrt{\sum_{k=1}^{d} \left( \frac{x_i^{(k)} - x_j^{(k)}}{\theta_k} \right)^2}$$

où $x_i^{(k)}$ est la k$^{ème}$ composante de $X_i$ ( le k$^{ème}$ paramètre). Les grandeurs $\theta_k$ sont souvent nommées les "portées" du paramètre k. Elles doivent être non nulles et sont usuellement choisies positives.

Un exemple classique *(mais non unique, il en existe bien d'autres)* de fonction de corrélation r(X , $X_j$) entre X et $X_j$ est:

$$r(X, X_j) = exp\left(-\|X - X_j\|^2\right) = exp\left(-\sum_{k=1}^{d}\left(\frac{x^{(k)} - x_j^{(k)}}{\theta_k}\right)^2\right)$$

Le métamodèle donné par le krigeage est de la forme :

$$f(X) = \sum_{j=1}^{p}\beta_j\, g_j(X) + \sum_{i=1}^{n}\lambda_i\, r(X, X_i)$$

où :

- X représente un point courant quelconque, c'est-à-dire un jeu de valeurs numériques des d paramètres.
- Les $X_i$, i variant de 1 à n, sont des vecteurs représentant les n points (ou simulations, effectuées avec le logiciel) de la base d'apprentissage, chacun de ces points étant un jeu de d valeurs numériques.
- Les p fonctions $g_j(X)$ sont choisies a priori et sont nommées "termes de tendances"
- $r(X, X_i)$ est la fonction de corrélation entre X et $X_i$
- Les p coefficients $\beta_j$ et les n coefficients $\lambda_i$ sont calculés d'après les réponses et paramètres de la base d'apprentissage.

Dans une variante du krigeage qui est le krigeage ordinaire, on a p=1 (1 seul terme de tendance) et $g_1(X) = 1$ (terme constant et unitaire).

Dans le krigeage universel qui est une autre variante du krigeage, il y a plusieurs termes de tendance. Un choix classique de krigeage universel est de prendre p = d + 1 et de choisir les d effets linéaires :

$$g_j(X) = x^{(j)}$$

et un terme constant $g_{d+1}(x) = 1$

Un autre choix classique de krigeage universel est de choisir les p termes les plus influents tels que déterminés par une analyse de la variance faite sur la base d'apprentissage avec comme fonctions candidates les différents monômes issu d'un polynôme de degré total 2 ou 3.

La manière d'obtenir les p coefficients $\beta_j$ et les n coefficients $\lambda_i$ est connue de l'homme de l'art et est décrite dans de nombreux ouvrages, par exemple dans l'ouvrage de Thomas J. SANTNER et Collaborateurs. Elle nécessite la résolution de systèmes linéaires de tailles n*n avec plusieurs seconds membres. Ce document décrit aussi des méthodes statistiques pour déterminer les portées $\theta_k$ optimales, mais ce sont souvent des méthodes itératives qui nécessitent des quantités de calcul assez importantes.

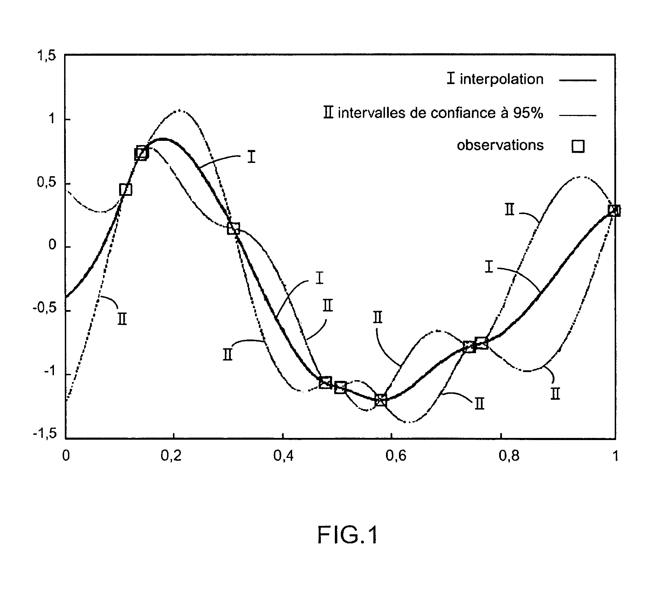

Le krigeage est une méthode classique de construire un interpolateur. On peut également utiliser les calculs intermédiaires du krigeage pour estimer (au prix de calculs un peu lourds) en chaque point un écart-type autour du méta-modèle et à partir des intervalles de confiances. Ces écart-types sont nuls pour les points d'apprentissage (c'est un interpolateur) et augmentent au fur et à mesure qu'on s'éloigne de ces points d'apprentissage. La figure 1 schématise ce comportement dans un cas monodimensionnel (d=1):

La manière d'obtenir ces écart-types est connue de l'homme de l'art. Elle est décrite dans de nombreux ouvrages, par exemple dans l'ouvrage précité de Thomas J. SANTNER et collaborateurs.

Le krigeage a cependant un certain nombre d'inconvénients:

- Le système linéaire n*n à résoudre est parfois peu stable, rendant sa résolution impossible ou très imprécise, en particulier lorsque n est relativement élevé (par exemple de l'ordre du millier ou plus) et que les points de la base d'apprentissage ne sont pas régulièrement répartis. Pour pallier cet inconvénient, on peut utiliser ce que l'homme de l'art appelle des "pépites" (technique décrite par exemple dans le document précité de Thomas J. SANTNER et collaborateurs) mais de ce fait le krigeage perd sa qualité première d'interpolateur.

- L'expérience prouve que l'aptitude du krigeage à bien reproduire le comportement du logiciel sur des points tests choisis dans le même domaine que les points d'apprentissages mais distincts de ceux-ci est parfois décevante, c'est-à-dire que l'erreur quadratique moyenne entre valeurs de la réponse prédite par le métamodèle et valeur de la réponse obtenue par simulation avec le logiciel est dans de tels cas anormalement grande.

L'invention concerne ainsi un procédé de construction d'un métamodèle pour interpoler des données à partir de simulations constituant une base d'apprentissage comportant des vecteurs $X_i$, i variant de 1 à n, présentant chacun des composantes $x_i^{(k)}$, k variant de 1 à d, **caractérisé en ce que** le métamodèle est une spline d'interpolation ou de quasi-interpolation multidimensionnelle pseudo-cubique de type plaque mince ayant une fonction analytique f(X)

$$f(X) = \sum_{i=1}^{n} \lambda_i \|X - X_i\|^3 + \sum_{k=1}^{d} \alpha_k x^{(k)} + \alpha_O$$

$$\|X - X_i\|^2 = \sum_{k=1}^{d} dil_k^2 \left( \frac{x^{(k)} - x_i^{(k)}}{\sigma_k} \right)^2$$

$\sigma_k$ désignant l'écart type des $k^{eme}$ composantes
et $dil_k$ une dilatation d'échelle éventuellement associée à ladite $k^{eme}$ composante ($dil_k$ est d'autant plus grand que les effets non linéaires associés à ce paramètre sont grands)
$\lambda_i$ et $\alpha_k$ étant les solutions d'un système linéaire symétrique de dimension $(n + d + 1)^2$ :

$$\sum_{j=1}^{n} \lambda_j \cdot \|X_j - X_i\|^3 + \frac{\lambda_i}{\rho \omega_i} + \sum_{k=1}^{d} \alpha_k \cdot x_i^{(k)} + \alpha_O = y_i \qquad \text{pour } i \in \{1, 2, 3, \ldots, n\}$$

$$\sum_{j=1}^{n} \lambda_j \cdot x_j^{(k)} = 0 \qquad \text{pour } k \in \{1, 2, 3, \ldots, d\}$$

$$\sum_{j=1}^{n} \lambda_j = 0$$

$y_i$ désignant la valeur de la réponse pour la $i^{eme}$ simulation pour la valeur $X_i$ des paramètres, $\omega_i$ étant un poids associé à la $i^{ème}$ simulation. Si les simulations ne sont pas pondérées, c'est-à-dire si elles ont toute la même importance, alors $\omega_i = 1$ quelque soit i.
$\rho$ est un paramètre de lissage, qui est infini pour une spline d'interpolation (vraie interpolation). D'une manière générale, plus le paramètre de lissage est grand, plus la variance résiduelle est petite. Le paramètre de lissage $\rho$ est considéré comme "grand" si le métamodèle ainsi obtenu est un quasi interpolateur. Le paramètre $\rho$ peut être par exemple choisi entre $10^3$ et $10^{12}$ et plus particulièrement entre $10^4$ et $10^{10}$.

Pour déterminer les dilatations d'échelle dil$_k$, le procédé peut être **caractérisé en ce qu**'on effectue les opérations suivantes :

a) partir d'une estimation initiale des d dilatations d'échelles dil$_k$
b) partitionner de manière aléatoire ou pseudo-aléatoire les n résultats de simulation X$_i$ en np parties disjointes (np $\geq$ 1),
c) itérer sur P parties avec P $\leq$ np
d) initialiser à zéro une variance de validation croisée
e) calculer une variance de validation croisée à partir des valeurs de dilatations d'échelle dil$_k$
f) choisir de nouvelles valeurs de dilatations d'échelle minimisant ladite variance de validation croisée obtenue lors de e, et
g) itérer à partir de c avec lesdites nouvelles valeurs de dilatation d'échelle

g') éventuellement entre e et f ou entre f et g tester la convergence selon un critère de convergence, et si ce critère est satisfait, sortir du processus itératif avec les valeurs de dilatations d'échelle en cours.

De préférence, P < np et les parties sont sélectionnées aléatoirement.
Pour calculer une variance de validation croisée, le procédé peut être **caractérisé en ce que** e comporte pour p variant entre 1 et P

e$_1$) supprimer provisoirement tous les résultats de simulation de cette partie
e$_2$) déterminer la fonction f(X) sans ces points.
e$_3$) utiliser la fonction f(X) uniquement pour recalculer les valeurs prédites sur les n$_q$ points provisoirement supprimés.
e$_4$) incrémenter la variance de validation croisée par la somme des carrés des écarts entre la valeur prédite sans les points provisoirement supprimés et la valeur de la simulation sur les points provisoirement supprimées, cette somme se faisant sur tous les points provisoirement supprimés.
e$_5$) réintégrer les points provisoirement supprimés.

La valeur de np peut être par exemple comprise entre 5 et 50.
Le procédé peut être **caractérisé en ce que** nq étant le nombre de résultats dans la q$^{ème}$ partie, nq est sensiblement le même pour chaque partie et notamment en ce que :

$$\sum_{q=1}^{np} n_q = n$$

Plus particulièrement, on peut avoir p = 1, np = n et nq = 1 quelque soit q.
Selon une variante préférée, ce procédé est **caractérisé en ce que,** pour calculer les dilatations d'échelle dil$_k$, il comporte :

a') Partir d'une estimation initiale de toutes les dilatations d'échelles, qui respecte la condition $\prod_{k=1}^{d} dil_k = 1$,

notamment dil$_k$ = 1 quelque soit k.
b') Construire la fonction spline multidimensionnelle pseudo-cubique type plaque mince f(X) avec ces dilatations d'échelles.
c') Calculer les d dérivées secondes de la fonction spline multidimensionnelle pseudo-cubique type plaque mince par rapport au d paramètres,

$$\frac{\partial^2 f(X_i)}{\partial x^{(k)^2}}$$

pour k=1 à d, et ce pour chacun des n points de la base d'apprentissage (i variant de 1 à n).

d') Calculer, pour chacun des d paramètres, la moyenne quadratique, sur l'ensemble des points de la base d'apprentissage, des dérivées secondes calculées à l'étape c, cette moyenne quadratique étant définie par :

$$SQD2F(k) = \sqrt{\frac{\sum_{i=1}^{n}\left(\frac{\partial^2 f(X_i)}{\partial x^{(k)^2}}\right)^2}{n}}$$

pour k variant de 1 à d

e') Calculer, pour ce jeu de dilatations d'échelles, une variance de validation croisée ou une variance de validation croisée généralisée.

f) A partir de la 2ème itération du processus itératif et si cet écart quadratique de validation croisée est plus grand que celui obtenu à l'itération précédente, sortir du processus itératif avec les valeurs des dilatations d'échelles de l'itération précédente et conserver la fonction spline multidimensionnelle pseudo-cubique type plaque mince pour ces dilatations d'échelles de l'itération précédente.

g') Calculer la moyenne géométrique C des quantités SQD2F(k) définies plus haut et pondérées par le carré de $\sigma_k$ :

$$C = \left(\prod_{k=1}^{d}\sigma_k^{\,2}\ SQD2F(k)\right)^{1/d}$$

h') Calculer de nouvelles dilatations d'échelles notamment par la formule :

$$new\_dil_k = \sigma_k\sqrt{\frac{SQD2F(k)}{C}}$$

i') Eventuellement, tester la convergence du processus itératif. Ceci peut être fait par exemple en testant le maximum des valeurs absolues des variations relatives entre $dil_k$ et $new\_dil_k$, c'est-à-dire en comparant la quantité

$$\max_{k=1\ à\ n}\left(\frac{|dil_k - new\_dil_k|}{dil_k}\right)$$

avec par exemple, un seuil de convergence prédéfini. Si cette quantité est inférieure au seuil de convergence, la convergence est réputée atteinte et on sort du processus itératif. On conserve les nouvelles dilatations d'échelles obtenue en h'.

$i_1$') (Optionnellement) Vérifier le bon déroulement du processus itératif, fait par exemple en vérifiant au moins une condition, à savoir si le nombre d'itérations est inférieur à un nombre maximum d'itération autorisé, et/ou si le rapport

$$\max(new\_dil_k, k=1\ à\ d) / \min(new\_dil_k, k=1\ à\ d)$$

est inférieur à un autre seuil prédéfini, et si une dite condition n'est pas vérifiée, sortir du processus itératif, max et min désignant le maximum et le minimum de la valeur des d paramètres entre parenthèses.

j') Actualiser les dilatations d'échelles, c'est-à-dire remplacer les $dil_k$, k=1 à d, par les $new\_dil_k$, k=1 à d, et retourner à l'étape b' pour la prochaine itération, à partir de ces dilatations d'échelles actualisées.

Pour calculer les dilatations d'échelle, il est avantageux dans le cas où le métamodèle est un quasi-interpolateur d'utiliser une variance de validation croisé généralisée GCV. A cet effet le procédé est **caractérisé en ce que** ladite variance de validation croisée est une variance généralisée GCV, avec :

$$GCV = \frac{\sum_{i=1}^{n} \omega_i \left( f(X_i) - y_i \right)^2}{\left( n - trace\left( A_\rho \right) \right)^2}$$

et $\displaystyle\sum_{i=1}^{n} \omega_i = n$,

et trace($A_\rho$) est la trace de la matrice de lissage $A_\rho$ qui fait passer du

vecteur Y des n réponses $y_i$ au vecteur F des n valeurs quasi-interpolées $f(X_i)$, :

soit F= $A_\rho$ •Y

avec F = $(f(X_1), f(X_2), ...., f(X_i), ... , f(X_n))^t$

et Y = $(y_1, y_2, ... , y_i, .... , y_n)^t$

l'indice t désignant la matrice transposée, la spline étant calculée avec un paramètre de lissage $\rho$ non infini, mais tel que le métamodèle soit considéré comme un quasi-interpolateur.

Le paramètre trace ($A_\rho$) peut être calculé notamment par une méthode de Monte-Carlo.

L'invention sera mieux comprise à la lecture de la description qui va suivre, la figure 1 illustrant les intervalles de confiance d'une méthode de krigeage selon l'art antérieur, dans le cas monodimensionnel, c'est-à-dire qu'il y a seulement d = 1 paramètre, avec en abscisse ce paramètre explicatif et en ordonnée la valeur du métamodèle, et les figures 2 et 3 étant des organigrammes correspondant à deux procédés de calcul des dilatations d'échelle.

L'idée de base de l'invention est donc d'utiliser comme métamodèles des splines d'interpolation ou de quasi-interpolation multidimensionnelles pseudo-cubiques type plaque mince. Ces splines, connues mais relativement rarement utilisées dans la littérature, font partie de la famille des splines multidimensionnelles invariantes par rotation et utilisent des fonctions radiales de base et sont connues de l'homme de l'art par le document suivant :

- J. Duchon, "Splines minimizing rotation-invariant semi-norms in Sobolev space", Lecture Notes in Mathematics, vol 571, pp85-100, 1977, also in the proceedings of a conference "Constructive Theory of Functions of Several Variables", held at Oberwolfach, april 25- May 1, 1976 and edited by W. Schemp and K. Zellers (Eds.), Berlin: Springer-Verlag pp.85-100.

La manière de résoudre un système linéaire symétrique est classique, très bien connue de l'homme de l'art, décrite dans de nombreux ouvrages, programmée dans de nombreux logiciels ou bibliothèques mathématiques.

Les familles de splines multidimensionnelles utilisées dans le cadre de la présente invention sont des fonctions

de $\Re^d$ dans $\Re$ , où d est la dimension de l'espace, c'est-à-dire le nombre de paramètres.

De manière générale, une spline de lissage est une fonction f qui minimise une énergie totale, somme d'une énergie de courbure et d'une variance résiduelle multipliée par le paramètre de lissage $\rho$ :

$$E_t = E_c(f) + \rho \cdot \sum_{i=1}^{n} \omega_i \left( f(X_i) - y_i \right)^2$$

où n est le nombre de points, $y_i$ la valeur de la réponse pour la i$^{ème}$ simulation et $X_i$ le vecteur des variables explicatives, c'est-à-dire des valeurs des d paramètres pour la i$^{ème}$ simulation, $\omega_i$ le poids affecté au i$^{ème}$ point ou simulation.

Chaque famille de spline se caractérise par l'expression de son énergie de courbure. L'énergie de courbure pour les splines multidimensionnelles pseudo cubiques type "plaque mince" est , d'après le document précité de J. DUCHON:

$$E_c(f) = \int_{R^d} \sum_{k=1}^{d} \sum_{p=1}^{d} \left[ Four\left( \frac{\partial^2 f}{\partial t_k \partial t_p} \right)(u) \right]^2 \|u\|^{d-1} du_1 \, du_2 \, .... \, du_d$$

d est la dimension de l'espace des variables explicatives et Four la transformée de Fourier dans $\Re^d$, le carré de la transformée de Fourier étant le carré de la norme.

La régression aux moindres carrés correspond au cas limite de $\rho \to 0$.

La spline d'interpolation correspond au cas limite de $\rho \to \infty$ : la spline doit passer par tous les points, c'est-à-dire que la variance résiduelle est nulle, et on en minimise l'énergie de courbure. Une spline d'interpolation est un cas limite d'une spline de lissage.

La spline de quasi-interpolation correspond au cas où le paramètre de lissage $\rho$ est grand, c'est-à-dire que la variance résiduelle est petite par rapport à la variance totale des $y_i$, c'est-à-dire que la variance résiduelle est inférieure à par exemple 0,01 fois la variance totale, ou, mieux, que la variance résiduelle est inféreire à par exemple 0,001 fois la variance totale, ou mieux encore, que la variance résiduelle est inférieure à par exemple 0,0001 fois la variance totale.

La variance résiduelle est ici définie (très classiquement) par :

$$Var\_résid = \sum_{j=1}^{n} \omega_j.(y_j - f(X_j))^2$$

et la variance totale est ici définie (classiquement) par :

$$Var\_totale = \sum_{j=1}^{n} \omega_j.(y_j - <y>)^2$$

ou $<y>$ est la valeur moyenne pondérée par les $\omega_i$ des n valeurs $y_i$.

L'utilisation de splines de lissage multidimensionnelles pseudo-cubiques type plaque mince pour analyser des résultats expérimentaux est déjà connue de l'homme de l'art, par exemple de la publication de F. DE CRECY "Pseudo-cubic thin-plate-spline method for analysing experimental data", paru dans Nuclear Engineering and Design, vol. 149, pp. 459-465 (1994).

La forme analytique d'une spline multidimensionnelle pseudo-cubique type plaque mince, qu'elle soit d'interpolation ou de lissage, est :

$$f(X) = \sum_{i=1}^{n} \lambda_i \|X - X_i\|^3 + \sum_{k=1}^{d} \alpha_k x^{(k)} + \alpha_o$$

où $x^{(k)}$ est la $k^{\text{ème}}$ composante (ou paramètre) de X , $X_i$ est le vecteur des d valeurs des paramètres pour la $i^{\text{ème}}$ simulation, et où la norme est définie par :

$$\|X - X_i\|^2 = \sum_{k=1}^{d} dil_k^2 \left( \frac{x^{(k)} - x_i^{(k)}}{\sigma_k} \right)^2$$

$\sigma_k$ étant une grandeur caractéristique positive associé aux $k^{èmes}$ composantes des $X_i$, par exemple l'écart-type des valeurs du $k^{èmes}$ composantes des $X_i$ (c'est-à-dire des valeurs du $k^{ème}$ paramètre) et où $dil_k$ est la dilatation d'échelle associée au $k^{ème}$ paramètre. Ces dilatations d'échelle traduisent, le cas échéant, l'importance relative des effets non linéaires des divers paramètres. Elles sont généralement choisies positives. Plus elles sont grandes, plus les effets non linéaires associés à ce paramètre sont importants. Il est fréquent et conseillé, mais non obligatoire, d'imposer une condition supplémentaire sur ces dilatations d'échelles, par exemple:

$$\prod_{k=1}^{d} dil_k = 1$$

Une telle spline est définie sur tout $\Re^d$. Quand on s'éloigne de la zone où il y a des points $X_i$, elle tend localement vers un hyperplan.

Pour chaque valeur du paramètre de lissage $\rho$ et des dilatations d'échelle $dil_k$, les coefficients $\lambda_j$ et $\alpha_k$ sont solutions d'un système linéaire symétrique de dimension (n+d+1) x (n+d+1). Ce système est :

$$\sum_{j=1}^{n} \lambda_j \cdot \left\| X_j - X_i \right\|^3 + \frac{\lambda_i}{\rho \cdot \omega_i} + \sum_{k=1}^{d} \alpha_k \cdot x_i^{(k)} + \alpha_o = y_i$$

pour $i \in \{1, 2, 3, ... , n\}$

$$\sum_{j=1}^{n} \lambda_j \cdot x_j^{(k)} = 0$$

pour $k \in \{1, 2, 3, ... , d\}$

$$\sum_{j=1}^{n} \lambda_j = 0$$

L'homme de l'art sait résoudre (avec un ordinateur) ce système linéaire. De nombreuses méthodes existent, dont les plus classiques sont décrites dans le document précité de W.H. PRESS et collaborateurs.

Les notations sont les mêmes que plus haut au sein de ce chapitre: en particulier, la norme fait intervenir les dilatations d'échelle. Les $y_i$ sont les grandeurs à lisser ou à interpoler (résultats des mesures ou réponse de simulations: $y_i$ est la valeur de la réponse pour la $i^{ème}$ simulation) pour la valeur $X_i$ des paramètres.

Une spline de lissage de quasi-interpolation est obtenue lorsque le paramètre de lissage $\rho$ est suffisamment grand pour que le métamodèle soit une quasi-interpolation.

Dans le cas d'une spline d'interpolation, on a $\rho = \infty$ et ce système se simplifie directement en :

$$\sum_{j=1}^{n} \lambda_j \cdot \left\| X_j - X_i \right\|^3 + \sum_{k=1}^{d} \alpha_k \cdot x_i^{(k)} + \alpha_o = y_i \qquad \text{pour } i \in \{1, 2, 3, ... , n\}$$

$$\sum_{j=1}^{n} \lambda_j \cdot x_j^{(k)} = 0 \qquad \qquad \text{pour } k \in \{1, 2, 3, \ldots, d\}$$

$$\sum_{j=1}^{n} \lambda_j = 0$$

La diagonale principale de la matrice associée à ce système linéaire symétrique ne comporte donc que des zéros dans le cas de l'interpolation.

Il est conseillé de choisir le cas échéant des dilatations d'échelle $dil_k$ associées aux divers paramètres, si on veut tenir compte des non-linéarités.

Une première variante est d'utiliser une méthode de type "Validation croisée"simple VVC. Les techniques de validation croisée sont classiques et sont décrites notamment dans l'article de Ron KOHAVI "A Study of Cross-validation and Bootstrap for Accuracy Estimation and Model Selection" International Joint Conference on Artificial Intelligence ISCA, 1995.

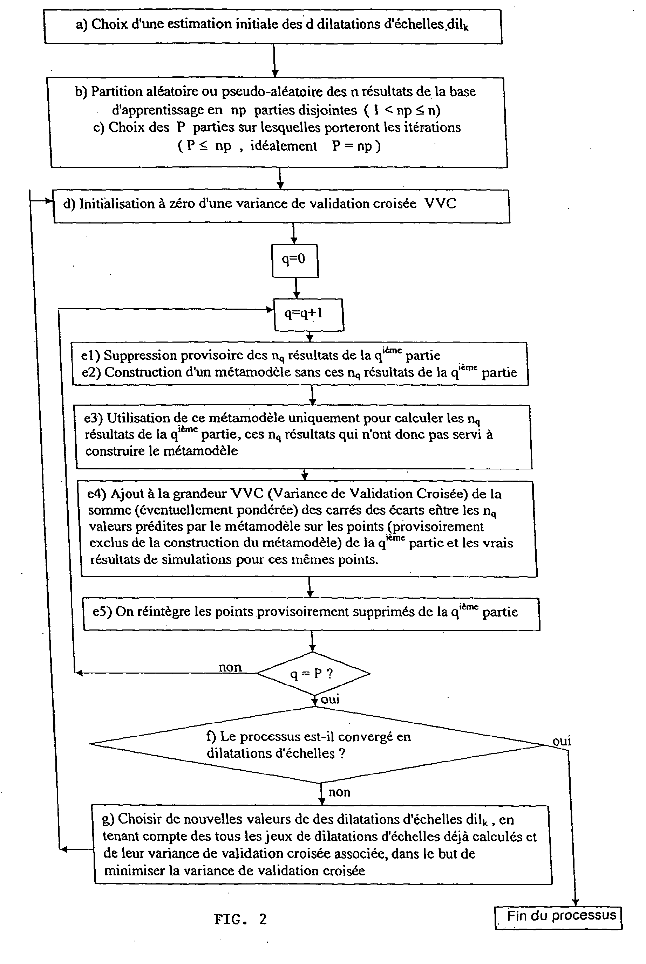

Elle comporte schématiquement dans la procédure suivante (voir figure 2) :

1. Partir d'une estimation initiale des d dilatations d'échelles, $dil_k$ , $k \in \{1, 2, 3, \ldots, d\}$.
2. Partitionner de manière aléatoire ou pseudo-aléatoire l'ensemble des n résultats de simulation de la base d'apprentissage en np parties disjointes. Un choix classique est de prendre np entre 5 et 50. Soit $n_q$ le nombre de résultats dans la $q^{ème}$ partie. Un choix classique est d'avoir le même ordre de grandeur de nq quelque soit la partie. Un choix conseillé est d'avoir $\sum_{q=1}^{np} n_q$ égal à n ou proche de n. Si on est très large en temps de calcul, un choix conseillé, sûr et robuste (mais long) est de prendre np=n et $n_q$=1, quelque soit q.
3. Choisir P parties sur lesquelles on va itérer. Il est préférable d'avoir P = np , mais cela entraîne souvent des calculs très longs. Aussi est-il parfois acceptable de prendre P < np. Les parties sélectionnées le sont aléatoirement.
4. Initialiser à zéro une variance de validation croisée ou VVC
5. Pour q = 1 à P : { itération sur les parties }

    a. Supprimer provisoirement tous les nq résultats de simulation de cette partie N˚ q, c'est-à-dire de la $q^{ème}$ partie de la partition évoquée à l'étape 2 ci-dessus
    b. Déterminer la spline sans ces points.
    c. Utiliser cette spline uniquement pour recalculer les valeurs prédites sur les nq points provisoirement supprimés.
    d. Incrémenter la variance de validation croisée VVC par la somme (éventuellement pondérée par les poids $\omega_i$) des carrés des écarts entre la valeur prédite par la spline sans les points provisoirement supprimés et la valeur de la vraie simulation, cette somme se faisant sur tous les nq points provisoirement supprimés.
    e. Réintégrer les points provisoirement supprimés.

6. Stocker la valeur de la variance VVC associée aux dilatations d'échelles $dil_k$ utilisées.
7. Choisir des nouvelles valeurs de dilatations d'échelles dans le but de minimiser la variance de validation croisée VVC. Il existe de nombreuses méthodes connues de l'homme de l'art pour choisir ces nouvelles valeurs de dilatations d'échelles, par exemple le "Simplex" ou les algorithmes génétiques ou la méthode de Powell "Direction Set Method". Ces méthodes de Simplex et de Powel sont décrites dans le livre précité de W. H. PRESS et Collaborateurs. Les algorithmes génétiques sont décrits dans de nombreux ouvrages, par exemple le livre de A.E. EIBEN et J.E. SMITH "Introduction to Evolutionary Computing" 2003, Springer.
8. Tester la convergence (par exemple faible variation de la variance VVC ou des dilatations d'échelles $dil_k$). Si on n'est pas convergé, on retourne à l'étape 4. Ce test peut aussi être effectué entre 6 et 7.

Une autre difficulté provient de ce que les différents paramètres peuvent avoir des gammes de variation extrêmement différentes les uns des autres, ce qui peut entraîner des problèmes de stabilité de la matrice associée au système linéaire (n+d+1)*(n+d+1) à résoudre si on les utilise directement, sans transformation. C'est pourquoi il est fortement conseillé de travailler sur des paramètres adimensionnalisés, par exemple centrés réduits suivant la formule :

$$x^{(k)+} = \frac{x^{(k)} - m_k}{\sigma_k}$$

où $m_k$ est la moyenne des valeurs du $k^{\text{ème}}$ paramètre et $\sigma_k$ est une grandeur caractéristique positive associée au $k^{\text{ème}}$ paramètre, par exemple l'écart-type des valeurs du $k^{\text{ème}}$ paramètre. C'est cette adimensionalisation qui a déjà été faite dans la définition de la norme utilisée plus haut.

Une difficulté peut parfois survenir, à savoir que la matrice associée au système linéaire (n+d+1)*(n+d+1) à résoudre est mal conditionnée, même avec des paramètres centrés réduits. Cela peut arriver par exemple quand la répartition des simulations dans $\Re^d$ est très irrégulière, avec quelques simulations beaucoup plus proches les unes des autres que la moyenne. La manière de résoudre cette difficulté est d'approximer la spline d'interpolation par une spline de lissage avec un paramètre de lissage $\rho$ très grand, par exemple dans la gamme [$10^3$ à $10^{10}$] si tous les paramètres et réponses ont été centrés et réduits. Avec des grandes valeurs du paramètre de lissage $\rho$, la spline de lissage est très proche de la spline d'interpolation: le métamodèle obtenu est un "quasi-interpolateur".

Une deuxième variante pour choisir les dilatations d'échelle (uniquement dans le cas du quasi-interpolateur, pas dans le cas du vrai interpolateur) est la validation croisée généralisée GCV. Cette autre manière est basée sur le fait qu'une bonne approximation de la variance de validation croisée simple VVC, définie plus haut, est GCV, nommée varianc e de validation croisée généralisée, définie par:

$$GCV = \frac{\sum_{i=1}^{n} \omega_i \left( f(X_i) - y_i \right)^2}{\left( n - trace\left( A_\rho \right) \right)^2}$$

où on a supposé que la moyenne des poids $\omega_i$ vaut 1, c'est-à-dire n que $\sum_{i=1}^{n} \omega_i = n$  et que trace($A_\rho$) est la trace de la matrice de lissage, la matrice de lissage $A_\rho$ étant la matrice qui fait passer du vecteur des n réponses $y_i$ aux n valeurs quasi-interpolées $f(X_i)$ :

$$F = A_\rho \bullet Y$$

le signe • désignant un produit matriciel
avec $F = (f(X_1), f(X_2), ...., f(X_i), ... , f(X_n))^t$ et $Y = (y_1, y_2, ... , y_i, .... , y_n)^t$

Il existe des méthodes de Monte-Carlo, connues de l'homme de l'art et par exemple décrites dans le document de D.A. Girard, "A Fast 'Monte-Carlo Cross-Validation' Procedure for Large Least Squares Problems with Noisy Data", Numerische Mathematik, Vol 56, pp1-23, 1989, pour trouver une bonne approximation de la trace de $A_\rho$ et par conséquent de GCV. Cette méthode est beaucoup plus économique en temps de calcul que la vraie validation croisée, mais elle est parfois un peu moins robuste et ne s'applique pas aux vrais interpolateurs.

Pour ces deux premières variantes, on itère sur les dilatations d'échelles pour minimiser respectivement VVC ou GCV. La manière de gérer ces itérations est bien connue de l'homme de l'art qui cherche à minimiser une fonction dans un espace de paramètres et les méthodes classiques du Simplex ou de Powell ("Direction Set Method") peuvent être utilisées.

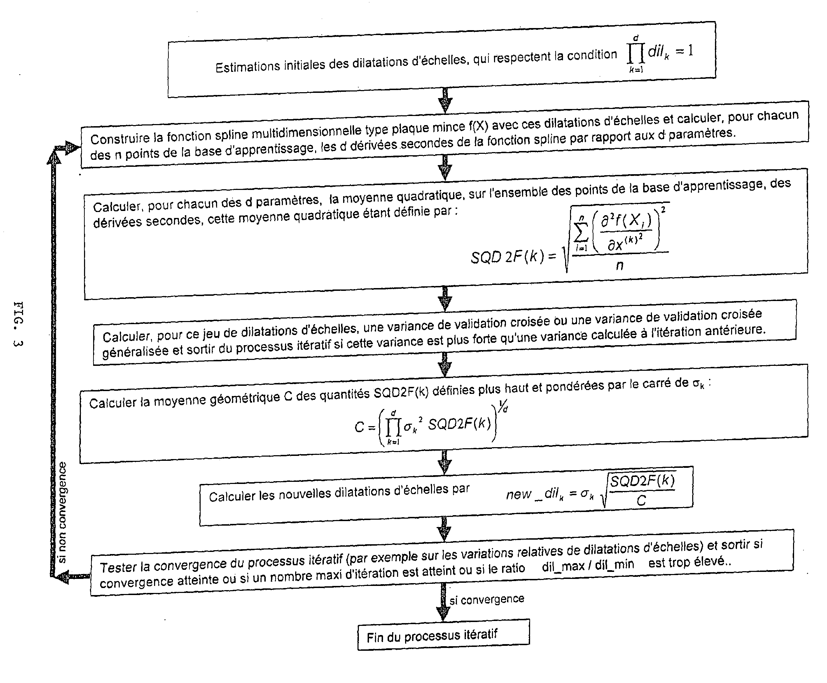

Une troisième variante, préférée illustrée par la figure 3, consiste à ne pas chercher à minimiser VVC ou GCV sur l'ensemble du domaine possible des dilatations d'échelles, mais seulement sur un chemin choisi. Le principal avantage de cette autre méthode est d'être beaucoup plus rapide en temps de calcul de l'unité centrale CPU pour des résultats d'optimisation généralement presque aussi bons.

Pour bien comprendre cette variante, faisons intervenir les variables intermédiaires $u^{(k)}$ définies par :

$$u^{(k)} = x^{(k)} \cdot \frac{dil_k}{\sigma_k}$$

Avec cette variable $u^{(k)}$, la norme utilisée dans la définition de la fonction spline multidimensionnelle pseudo-cubique type plaque mince h(U) devient la classique norme euclidienne:

$$h(U) = \sum_{i=1}^{n} \lambda_i \|U - U_i\|^3 + \sum_{k=1}^{d} \alpha_k u^{(k)} + \alpha_o$$

où U est le vecteur dont les d composantes sont définies par :

$$u^{(k)} = x^{(k)} \cdot \frac{dil_k}{\sigma_k}$$

et où les $U_i$ sont obtenues de la même manière à partir des points $X_i$ de la base d'apprentissage. Les d composantes de $U_i$ sont obtenues à partir des d composantes des $X_i$ par la formule :

$$u_i^{(k)} = x_i^{(k)} \cdot \frac{dil_k}{\sigma_k}$$

La norme qui intervient est alors la norme euclidienne classique :

$$\|U - U_i\|^2 = \sum_{k=1}^{d} \left( u^{(k)} - u_i^{(k)} \right)^2$$

On remarquera que les coefficients $\lambda$ sont les mêmes, qu'on exprime la spline sous la forme f(X) ou h(U).

L'idée de base de cette méthode innovante est qu'on cherche à minimiser VVC ou GCV sur le chemin qui vise à avoir la même somme quadratique des dérivées secondes de h(U) par rapport à ses diverses composantes $u^{(k)}$, la somme se faisant sur l'ensemble des points de la base d'apprentissage.

La somme quadratique des dérivées secondes de h(U) par rapport à sa composante $u^{(k)}$, SQD2U(k), est définie par:

$$SQD2U(k) = \sqrt{\frac{\sum_{i=1}^{n} \left( \frac{\partial^2 h(U_i)}{\partial u^{(k)^2}} \right)^2}{n}}$$

la sommation se faisant sur les n points de la base d'apprentissage exprimés en U.

On peut calculer une quantité similaire à partir de la spline f(X) exprimée en X :

$$SQD2F(k) = \sqrt{\frac{\sum_{i=1}^{n}\left(\frac{\partial^2 f(X_i)}{\partial x^{(k)^2}}\right)^2}{n}}$$

La relation liant $u^{(k)}$ et $x^{(k)}$ implique que:

$$\frac{\partial^2 h(U_i)}{\partial u^{(k)^2}} = \frac{\partial^2 f(X_i)}{\partial x^{(k)^2}} * \left(\frac{\sigma_k}{dil_k}\right)^2$$

et que donc :

$$SQD2U(k) = SQD2F(k)*(\sigma_k/dil_k)^2$$

La minimisation de VVC ou de GCV se fait sur le chemin qui vise à avoir le même $SQD2U(k)$ pour tous les paramètres k, tout en respectant la contrainte que le produit de toutes les dilatations d'échelles est égal à 1.
Pour cela, une méthode proposée est le processus itératif suivant :

1. On part d'une estimation initiale de toutes les dilatations d'échelles, qui respecte la condition :

$$\prod_{k=1}^{d} dil_k = 1$$

Si on n'a pas de connaissance préalable de ces dilatations d'échelles initiales, les choisir toutes égales à 1 est généralement un bon choix.
2. Construire la fonction spline multidimensionnelle pseudo-cubique type plaque mince avec ces dilatations d'échelles, comme expliqué plus haut.
3. Calculer les d dérivées secondes de la fonction spline multidimensionnelle pseudo-cubique type plaque mince par rapport au d paramètres,

$$\frac{\partial^2 f(X_i)}{\partial x^{(k)^2}}$$

pour k=1 à d,
et ce pour chacun des n points de la base d'apprentissage ( i = 1 à n ).
4. Calculer, pour chacun des d paramètres, la moyenne quadratique (sur l'ensemble des points de la base d'apprentissage) des dérivées secondes calculées à l'étape précédente, cette moyenne quadratique étant définie par :

$$SQD2F(k) = \sqrt{\frac{\sum_{i=1}^{n}\left(\frac{\partial^2 f(X_i)}{\partial x^{(k)^2}}\right)^2}{n}}$$

pour k = 1 à d

5. Calculer, pour ce jeu de dilatations d'échelles, soit la variance de validation croisée VVC, soit la variance de validation croisée généralisée GCV, ces deux grandeurs ayant été définies plus haut et la manière de les calculer ayant été indiquée.

6. Si on n'est pas à la 1ère itération du processus itératif et si cette quantité VVC ou GCV est plus grande que celle obtenue à l'itération précédente, sortir du processus itératif avec les valeurs des dilatations d'échelles de l'itération précédente et en recalculant ou en restaurant la fonction spline multidimensionnelle pseudo-cubique type plaque mince pour ces dilatations d'échelles de l'itération précédente.

7. Calculer la moyenne géométrique C des quantités SQD2F(k) définies plus haut et pondérées par le carré de $\sigma_k$ :

$$C = \left(\prod_{k=1}^{d} \sigma_k^2 \; SQD2F(k)\right)^{1/d}$$

8. Conceptuellement, cette quantité représente la valeur moyenne géométrique des SQD2U(k).

9. Calculer des nouvelles dilatations d'échelles par une formule telle que:

$$new\_dil_k = \sigma_k \sqrt{\frac{SQD2F(k)}{C}}$$

10. Tester la convergence du processus itératif. Ceci peut être fait par exemple en testant le maximum des valeurs absolues des variations relatives entre $dil_k$ et $new\_dil_k$, c'est-à-dire en comparant la quantité

$$\max_{k=1 \, \dot{a} \, n}\left(\frac{|dil_k - new\_dil_k|}{dil_k}\right)$$

à, par exemple, un seuil de convergence prédéfini. Si cette quantité est inférieure au seuil de convergence, la convergence est réputée atteinte et on doit sortir du processus itératif.

11. Vérifier le bon déroulement du processus itératif. Ceci peut être fait par exemple en vérifiant si le nombre d'itérations est inférieur au nombre maximum d'itération autorisé, et par exemple aussi en vérifiant si le ratio max($new\_dil_k$ , k=1 à d) / min($new\_dil_k$ , k=1 à d) est inférieur à un autre seuil prédéfini. Si par exemple une de ces deux conditions n'est pas vérifiée, sortir du processus itératif.

12. Actualiser les dilatations d'échelles, c'est-à-dire remplacer les $dil_k$ , k=1 à d , par les $new\_dil_k$ , k=1 à d, et retourner à l'étape 2 pour la prochaine itération.

L'utilisation, à l'étape 5 du processus ci-dessus, de la variance de validation croisée VVC ou de la variance de validation croisée généralisée GCV correspond à deux variantes possibles de ce mode de réalisation de l'invention. L'utilisation de la variance de validation croisée généralisée GCV est généralement plus rapide en temps de calcul, mais est parfois moins robuste et ne s'applique pas aux vrais interpolateurs mais aux quasi-interpolateurs. L'utilisation de la variance de validation croisée VVC est plus robuste et est conseillée chaque fois qu'on peut se permettre le surcoût en temps de calcul tout en conservant un nombre de parties dans la partition suffisamment élevé, par exemple supérieur à 10 ou 15, et en utilisant toutes ces parties dans le calcul de VVC, c'est à dire que P=np dans l'étape 5 de la description du mode de calcul de la méthode "validation croisée". L'utilisation de VVC et non pas de GCV est aussi fortement conseillée quand on utilise un vrai interpolateur et non pas un quasi-interpolateur.

Lorsque les simulations sont pondérées, c'est-à-dire affectées de poids $\omega_i$ non tous égaux entre eux, une variante conseillée du mode de réalisation de l'invention est de prendre SQD2F(k), aux étapes 4 et suivantes du processus itératif ci-dessus, comme moyenne quadratique pondérée (sur l'ensemble des points de la base d'apprentissage) des dérivées secondes calculées à l'étape précédente, cette moyenne quadratique pondérée étant définie par :

$$ SQD2F(k) = \sqrt{ \frac{ \sum_{i=1}^{n} \omega_i \left( \frac{\partial^2 f(X_i)}{\partial x^{(k)^2}} \right)^2 }{ \sum_{i=1}^{n} \omega_i } } $$

pour k = 1 à d

Les principaux avantages apportés par cette invention sont les suivants:

- Le métamodèle construit avec la spline d'interpolation multidimensionnelle pseudo-cubique type plaque mince est bien un interpolateur ou un quasi-interpolateur, ce qui est un avantage considérable par rapport aux polynômes.
- L'expérience montre que le système linéaire à résoudre pour la spline d'interpolation multidimensionnelle pseudo-cubique type plaque mince est plus stable numériquement que le système linéaire à résoudre pour le krigeage.
- Il n'est pas nécessaire de faire le choix, toujours un peu arbitraire, des termes de tendance du krigeage universel.
- La spline d'interpolation multidimensionnelle pseudo-cubique type plaque mince est le seul interpolateur qui minimise l'énergie de courbure susmentionnée.
- La spline d'interpolation multidimensionnelle pseudo-cubique type plaque mince est une fonction qui devient rapidement très lisse quand on s'éloigne des points expérimentaux. Au fur et à mesure qu'on s'éloigne des zones où il y a les points expérimentaux, la spline tend localement vers un hyperplan.
- L'expérience montre que la spline d'interpolation multidimensionnelle pseudo-cubique type plaque mince arrive mieux à retrouver (par rapport au krigeage) des points tests qui n'ont pas servi à bâtir la spline et qui sont dans la même gamme de paramètres.
- La spline d'interpolation multidimensionnelle pseudo-cubique type plaque mince est un peu plus rapide à utiliser que le krigeage. L'ordinateur a à calculer des racines carrées au lieu d'exponentielles.
- Il n'y a aucune contrainte sur l'emplacement des simulations dans l'espace des paramètres $\Re^d$. Si plusieurs simulations sont au même endroit dans l'espace des paramètres $\Re^d$, il suffit de n'en retenir qu'une seule de ces simulations (qui donnent le même résultat, puisque le logiciel est supposé déterministe).
- Si le logiciel n'est pas parfaitement déterministe et qu'il fournit des réponses avec une certaine variabilité, on peut passer continûment de la spline d'interpolation à une spline de quasi-interpolation en jouant sur le paramètre de lissage ρ.
- Il est possible de dériver indéfiniment la spline d'interpolation multidimensionnelle pseudo-cubique type plaque mince presque partout, sauf sur les points expérimentaux où elle est de classe $C^2$, c'est-à-dire qu'on peut la dériver 2 fois sur les points expérimentaux et que toutes les dérivées partielles d'ordre total inférieur ou égal à 2 sont définies et continues.
- La spline d'interpolation multidimensionnelle pseudo-cubique type plaque mince permet d'utiliser un nombre d de paramètres assez élevé. L'expérience montre qu'il n'y a pas d'inconvénient à ce que ce nombre d de paramètres soit de l'ordre de 30 ou même supérieur. Il faut par contre qu'il reste nettement inférieur au nombre n de simulations faites.

L'invention s'applique à des procédés de simulations déterministes dans tous les secteurs techniques et industriels. Elle peut donc concerner une très large gamme d'applications, parmi lesquels on peut citer à titre d'exemple : la microélectronique et les micro- et nano-technologies *(avec par exemple les logiciels de "TCAD" (Technology Computer Aided Design), les logiciels de "SPICE" (Simulation Program with Integrated Circuit Emphasis))*, la construction mécanique et automobile, les télécommunications, les techniques aéronautique et/ou spatiale, le bâtiment et les travaux publics, la chimie, l'extraction minière, pétrolière et gazière, l'énergie, l'agro-alimentaire, le transport, etc...

**Revendications**

1. Procédé de construction d'un métamodèle pour interpoler des données techniques à partir de simulations constituant une base d'apprentissage comportant des vecteurs de données techniques $X_i$, i variant de 1 à n, présentant chacun des composantes $x_i^{(k)}$, k variant de 1 à d, **caractérisé en ce que** le métamodèle est une spline d'interpolation ou de quasi-interpolation multidimensionnelle pseudo-cubique de type plaque mince ayant une fonction analytique f(X)

$$f(X) = \sum_{i=1}^{n} \lambda_i \|X - X_i\|^3 + \sum_{k=1}^{d} \alpha_k x^{(k)} + \alpha_O$$

$$\|X - X_i\|^2 = \sum_{k=1}^{d} dil_k^2 \left( \frac{x^{(k)} - x_i^{(k)}}{\sigma_k} \right)^2$$

$\sigma_k$ désignant l'écart type des $k^{eme}$ composantes $X_i^{(k)}$ des vecteurs $X_i$
et $dil_k$ la dilatation d'échelle associée à ladite $k^{eme}$ composante
$\lambda_i$ et $\alpha_k$ étant les solutions d'un système linéaire symétrique de dimension $(n + d + 1)^2$ :

$$\sum_{j=1}^{n} \lambda_j \cdot \|X_j - X_i\|^3 + \frac{\lambda_i}{\rho \omega_i} + \sum_{k=1}^{d} \alpha_k \cdot x_i^{(k)} + \alpha_O = y_i$$

pour $i \in \{1, 2, 3, ... , n\}$

$$\sum_{j=1}^{n} \lambda_j \cdot x_j^{(k)} = 0$$

pour $k \in \{1, 2, 3, ... , d\}$

$$\sum_{j=1}^{n} \lambda_j = 0$$

$y_i$ désignant la valeur de la réponse pour la $i^{eme}$ simulation pour la valeur $X_i$ des paramètres, $\rho$ étant un paramètre de lissage dont la valeur est infinie pour une vraie interpolation, $\omega_i$ étant un poids associé à la $i^{ème}$ simultion.

2. Procédé selon la revendication 1, **caractérisé en ce que** pour déterminer des dilatations d'échelles $dil_k$, on effectue les opérations suivantes :

   a) partir d'une estimation initiale des d dilatations d'échelles $dil_k$
   b) partitionner de manière aléatoire ou pseudo-aléatoire les n résultats de simulation $X_i$ en np parties disjointes

(p $\geq$ 1),

c) itérer sur P parties avec P $\leq$ np

d) initialiser à zéro une variance de validation croisée

e) calculer une variance de validation croisée à partir des valeurs de dilatations d'échelle $dil_k$

f) choisir de nouvelles valeurs de dilatations d'échelle minimisant ladite variance de validation croisée obtenue lors de e, et

g) itérer à partir de e avec lesdites nouvelles valeurs de dilatation d'échelle

g') éventuellement entre e et f ou entre f et g tester la convergence selon un critère de convergence, et si ce critère est satisfait, sortir du processus itératif avec les valeurs de dilatations d'échelle en cours.

3.  Procédé selon la revendication 2, **caractérisé en ce que** P < np et **en ce que** les parties sont sélectionnées aléatoirement.

4.  Procédé selon une des revendications 2 ou 3, **caractérisé en ce que** e comporte, pour p variant entre 1 et P

$e_1$) supprimer provisoirement tous les résultats de simulation de cette partie

$e_2$) déterminer la fonction f(X) sans ces points.

$e_3$) utiliser la fonction f(X) uniquement pour recalculer les valeurs prédites sur les nq points provisoirement supprimés.

$e_4$) incrémenter la variance de validation croisée par la somme des carrés des écarts entre la valeur prédite sans les points provisoirement supprimés et la valeur de la simulation sur les points provisoirement supprimées, cette somme se faisant sur tous les points provisoirement supprimés.

$e_5$) réintégrer les points provisoirement supprimés.

5.  Procédé selon une des revendications 2 à 4, **caractérisé en ce que** la valeur de np est comprise entre 5 et 50.

6.  Procédé selon une des revendications 2 à 5, **caractérisé en ce que** nq étant le nombre de résultats dans la $q^{me}$ partie, nq est sensiblement le même pour chaque partie.

7.  Procédé selon la revendication 6, **caractérisé en ce que**

$$\sum_{q=1}^{np} n_q = n$$

8.  Procédé selon la revendication 7, **caractérisé en ce que** p = 1, et donc np = n, et **en ce que** nq = 1 quelque soit q.

9.  Procédé selon la revendication 1, **caractérisé en ce que** pour calculer les dilatations d'échelle $dil_k$, il comporte :

a') Partir d'une estimation initiale de toutes les dilatations d'échelles, qui respecte la condition $\prod_{k=1}^{d} dil_k = 1$, notamment $dil_k = 1$ quelque soit k.

b') Construire la fonction spline multidimensionnelle pseudo-cubique type plaque mince f(X) avec ces dilatations d'échelles.

c') Calculer les d dérivées secondes de la fonction spline multidimensionnelle pseudo-cubique type plaque mince par rapport aux d paramètres, $\dfrac{\partial^2 f(X_i)}{\partial x^{(k)^2}}$ pour k=1 à d, et ce pour chacun des n points de la base d'apprentissage (i variant de 1 à n).

d') Calculer, pour chacun des d paramètres, la moyenne quadratique sur l'ensemble des points de la base d'apprentissage, des dérivées secondes calculées à l'étape c', cette moyenne quadratique étant définie par :

$$SQD2F(k) = \sqrt{\dfrac{\sum\limits_{i=1}^{n}\left(\dfrac{\partial^2 f(X_i)}{\partial x^{(k)2}}\right)^2}{n}}$$

pour k compris entre 1 à d

e') Calculer, pour ce jeu de dilatations d'échelles, une variance de validation croisée ou une variance de validation croisée généralisée.

f) A partir de la 2$^{ème}$ itération du processus itératif et si ladite variance est plus grande que celle obtenue à l'itération précédente, sortir du processus itératif avec les valeurs des dilatations d'échelles de l'itération précédente et conserver la fonction spline multidimensionnelle pseudo-cubique type plaque mince pour ces dilatations d'échelles de l'itération précédente.

g') Calculer la moyenne géométrique C des quantités SQD2F(k) définies plus haut et pondérées par le carré de $\sigma_k$ :

$$C = \left(\prod_{k=1}^{d} \sigma_k{}^2\ SQD2F(k)\right)^{1/d}$$

cette quantité représentant la valeur moyenne géométrique des SQD2U(k).

h') Calculer des nouvelles dilatations d'échelles notamment par la formule suivante:

$$new\_dil_k = \sigma_k \sqrt{\dfrac{SQD2F(k)}{C}}$$

i') éventuellement tester la convergence du processus itératif et sortir du processus itératif avec lesdites nouvelles dilatations d'échelles obtenues en h'.

j') Actualiser les dilatations d'échelles, c'est-à-dire remplacer les $dil_k$ , k=1 à d , par les $new\_dil_k$ , k=1 à d, et retourner à l'étape b' pour la prochaine itération.

**10.** Procédé selon la revendication 9, **caractérisé en ce que** le test de convergence à l'étape i') prévoit de tester le maximum des valeurs absolues des variations relatives entre $dil_k$ et $new\_dil_k$, c'est-à-dire en comparant la quantité

$$max_{k=1\ à\ n}\left(\dfrac{\left|dil_k - new\_dil_k\right|}{dil_k}\right)$$

avec un seuil de convergence prédéfini, et si cette quantité est inférieure au seuil de convergence, sortir du processus itératif.

**11.** Procédé selon une des revendications 9 ou 10, **caractérisé en ce qu'**il comporte entre i' et j', une étape i'$_1$) pour vérifier au moins une condition, à savoir que le nombre d'itérations est inférieur au nombre maximum d'itération autorisé, et/ou que le rapport

$$\text{max(new\_dil}_k , k=1 \text{ à d) / min(new\_dil}_k , k=1 \text{ à d)}$$

est inférieur à une valeur seuil prédéfinie, et si une dite condition n'est pas vérifiée, sortir du processus itératif.

**12.** Procédé selon une des revendications 2 à 11, **caractérisé en ce que** le métamodèle est un métamodèle de quasi-interpolation et **en ce que** ladite variance de validation croisée est une variance généralisé GCV, avec :

$$GCV = \frac{\sum_{i=1}^{n} \omega_i (f(X_i) - y_i)^2}{(n - trace(A_\rho))^2}$$

et

$$\sum_{i=1}^{n} \omega_i = n,$$

et trace($A_\rho$) est la trace de la matrice de lissage $A_\rho$ qui fait passer du vecteur Y des n réponses $y_i$ au vecteur F des n valeurs quasi-interpolées $f(X_i)$, :

soit F= $A_\rho$ •Y

avec F = $(f(X_1), f(X_2), ...., f(X_i), ... , f(X_n))^t$

et Y = $(y_1, y_2, ... , y_i, .... , y_n)^t$

l'indice t désignant la matrice transposée, la spline étant calculée avec un paramètre de lissage $\rho$ compris entre $10^4$ et $10^{10}$.

**13.** Procédé selon la revendication 12, **caractérisé en ce que** trace ($A_\rho$) est déterminée par une méthode de Monte-Carlo.

FIG.1

a) Choix d'une estimation initiale des d dilatations d'échelles $dil_k$

b) Partition aléatoire ou pseudo-aléatoire des n résultats de la base d'apprentissage en np parties disjointes ( $1 < np \leq n$)
c) Choix des P parties sur lesquelles porteront les itérations ( $P \leq np$ , idéalement $P = np$ )

d) Initialisation à zéro d'une variance de validation croisée VVC

q=0

q=q+1

e1) Suppression provisoire des $n_q$ résultats de la $q^{ième}$ partie
e2) Construction d'un métamodèle sans ces $n_q$ résultats de la $q^{ième}$ partie

e3) Utilisation de ce métamodèle uniquement pour calculer les $n_q$ résultats de la $q^{ième}$ partie, ces $n_q$ résultats qui n'ont donc pas servi à construire le métamodèle

e4) Ajout à la grandeur VVC (Variance de Validation Croisée) de la somme (éventuellement pondérée) des carrés des écarts entre les $n_q$ valeurs prédites par le métamodèle sur les points (provisoirement exclus de la construction du métamodèle) de la $q^{ième}$ partie et les vrais résultats de simulations pour ces mêmes points.

e5) On réintègre les points provisoirement supprimés de la $q^{ième}$ partie

non ⟵ q = P ?

oui

f) Le processus est-il convergé en dilatations d'échelles ?     oui

non

g) Choisir de nouvelles valeurs de des dilatations d'échelles $dil_k$ , en tenant compte des tous les jeux de dilatations d'échelles déjà calculés et de leur variance de validation croisée associée, dans le but de minimiser la variance de validation croisée

Fin du processus

FIG. 2

EP 2 144 179 A1

FIG. 3

Estimations initiales des dilatations d'échelles, qui respectent la condition $\prod_{k=1}^{d} dil_k = 1$

Construire la fonction spline multidimensionnelle type plaque mince f(X) avec ces dilatations d'échelles et calculer, pour chacun des n points de la base d'apprentissage, les d dérivées secondes de la fonction spline par rapport aux d paramètres.

Calculer, pour chacun des d paramètres, la moyenne quadratique, sur l'ensemble des points de la base d'apprentissage, des dérivées secondes, cette moyenne quadratique étant définie par :

$$SQD\,2F(k) = \sqrt{\frac{\sum_{i=1}^{n}\left(\frac{\partial^2 f(X_i)}{\partial x^{(k)^2}}\right)^2}{n}}$$

Calculer, pour ce jeu de dilatations d'échelles, une variance de validation croisée ou une variance de validation croisée généralisée et sortir du processus itératif si cette variance est plus forte qu'une variance calculée à l'itération antérieure.

Calculer la moyenne géométrique C des quantités SQD2F(k) définies plus haut et pondérées par le carré de $\sigma_k$ :

$$C = \left(\prod_{k=1}^{d}\sigma_k^2\ SQD2F(k)\right)^{1/d}$$

Calculer les nouvelles dilatations d'échelles par $\quad new\_dil_k = \sigma_k\sqrt{\frac{SQD2F(k)}{C}}$

Tester la convergence du processus itératif (par exemple sur les variations relatives de dilatations d'échelles) et sortir si convergence atteinte ou si un nombre maxi d'itération est atteint ou si le ratio dil_max / dil_min est trop élevé..

si non convergence

si convergence

Fin du processus itératif

Europäisches
Patentamt

European
Patent Office

Office européen
des brevets

**RAPPORT DE RECHERCHE EUROPEENNE**

Numéro de la demande

EP 09 29 0527

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| D,A | DE CRECY F: "Pseudo-cubic thin-plate-type spline method for analysing experimental data" NUCLEAR ENGINEERING AND DESIGN NETHERLANDS, vol. 149, septembre 1994 (1994-09), pages 459-465, XP002518496 ISSN: 0029-5493 le document en entier, en particulier "4.1 Basic solution" | 1-13 | INV. G06F17/50 |
| A | SIMPSON T W ET AL: "Metamodels for computer-based engineering design: survey and recommendations" ENGINEERING WITH COMPUTERS, SPRINGER, BERLIN, DE, vol. 17, no. 2, 1 janvier 2001 (2001-01-01), pages 129-150, XP002402392 ISSN: 0177-0677 le document en entier | 1-13 | |
| A | SIMON N. WOOD: "Thin plate regression splines" JOURNAL OF THE ROYAL STATISTICAL SOCIETY: SERIES B (STATISTICAL METHODOLOGY), vol. 65, no. 1, 28 janvier 2003 (2003-01-28), pages 95-114, XP002518497 published online 28.01.2003 le document en entier, en particulier "1. Introduction" et "2. Low rank thin plate spline like smoothers" | 1-13 | **DOMAINES TECHNIQUES RECHERCHES (IPC)** G06F |

Le présent rapport a été établi pour toutes les revendications

| Lieu de la recherche | Date d'achèvement de la recherche | Examinateur |
|---|---|---|
| Munich | 14 septembre 2009 | Lerbinger, Klaus |

## RÉFÉRENCES CITÉES DANS LA DESCRIPTION

**Littérature non-brevet citée dans la description**

- **Thomas J. Santner ; Brian J. Williams, William ; I. Notz.** Design and Analysis of Computer Experiments. *Springer Series in Statistics,* 2003
- **G.E.P. Box ; N.R. Draper.** Empirical Model-Building and Response Surfaces. *Wiley series in Probability and Mathematical Statistics,* 1987
- **W.H. Press ; S.A. Teukolsky ; W.T. Vetterling ; B.P. Flannery.** Numerical Recipes, The Art of Scientific Computing. Cambridge University Press, 2007
- **J. Duchon.** Splines minimizing rotation-invariant semi-norms in Sobolev space. *Lecture Notes in Mathematics,* 1977, vol. 571, 85-100
- Constructive Theory of Functions of Several Variables. Springer-Verlag, 25 Avril 1976, 85-100
- **F. DE CRECY.** Pseudo-cubic thin-plate-spline method for analysing experimental data. *Nuclear Engineering and Design,* 1994, vol. 149, 459-465
- **Ron KOHAVI.** A Study of Cross-validation and Bootstrap for Accuracy Estimation and Model Selection. *International Joint Conference on Artificial Intelligence ISCA,* 1995
- **A.E. EIBEN ; J.E. SMITH.** Introduction to Evolutionary Computing. Springer, 2003
- **D.A. Girard.** A Fast 'Monte-Carlo Cross-Validation' Procedure for Large Least Squares Problems with Noisy Data. *Numerische Mathematik,* 1989, vol. 56, 1-23